# EUROPEAN PATENT APPLICATION

(11) **EP 1 018 763 A2**
(43) Date of publication of application: **12.07.2000**
(21) Application number: 99310139.3
(22) Date of filing: 16.12.1999
(51) Int. Cl.: H01L 23/367, H01L 21/48

(54) **An improved heatsink assembly**

(30) Priority: 18.12.1998 GB 9827867
(71) Applicant: ALSTOM UK LTD, Rugby Warwickshire CV21 1TB (GB)
(72) Inventor: Jones, Rodney, Newcastle, Staffs ST5 2JE (GB); Gowans, Thomas, Rode Heath, Stoke-on-Trent ST7 3TL (GB)
(74) Representative: Spall, Christopher John

(57) **Abstract**

A heatsink assembly is disclosed which comprises a base portion (2) of a thermally conductive material and at least one fin (10) co-operating along one edge with the base portion (2) and made of a thermally conductive material. The fin (10) is made of sheet material such as aluminium and a part of the fin is displaced out of the plane of the sheet. Adjacent fins define channels through which cooling air can be passed, with the displaced portions introducing turbulence in the channels to help remove warm air.

## Description

This invention relates to improvements in heatsink assemblies.

It is known to provide heatsink assemblies of the kind comprising a substantially planar base portion having a plurality of thin fins extending therefrom. The heatsink is constructed from a thermally conductive material and the provision of the fins increases the surface area of the heatsink within a given volume of space and for a given amount of material.

In use, an electrical component to be cooled, such as a power transistor, is thermally connected to the planar base using a thermally conductive paste. The heat transferred through the body and dissipated from the surface of the fins. A cooling fan can blow cool air across the fins, removing air which has been heated by the fins.

To form a complex heatsink is quite difficult if a mould has to be designed. One way of improving the manufacture of the assemblies which has been proposed is to bond separate planar fins onto a base portion. This enables the base portion to be fabricated from a different material from the fins and also for the fins to be produced cheaply from flat sheet material. In use, heat transfers from the base portion to the fins in a similar manner to a unitary heatsink assembly.

A problem with such prior art heatsinks has been identified by the applicant. In particular, it has been noticed that the heat transferring through the heatsink produces a layer of warm air at the root of the fins and cooler air at the tips of the fins. This can produce localised hot spots at the base of the fins, reducing the effective heat capacity of the heatsink.

In accordance with a first aspect, the invention provides a heatsink assembly comprising: a base portion of a thermally conductive material and at least one fin co-operating along one edge with the base portion and being made of a thermally conductive material said fin comprising a sheet-like element of which one or more portions of the fin are displaced out of the plane of the sheet.

Preferably the fin is in direct thermal contact with the base portion.

Each sheet-like element may be substantially planar, or curved along its length for example.

Of course, it will be appreciated that in general a number of fins will be provided, although they do not all require displaced portions.

By providing sheet like fins, with portions of the fins displaced out of the plane of the fin turbulence is introduced into the air flowing past the fins. This prevents the warm air from sitting in a layer at the base of the fins, thereby improving heat dissipation.

Preferably, the fins are arranged substantially orthogonal to the base. Each fin may be substantially parallel to its adjacent fin to define channels between the fins. By providing displaced portions, the sides of the channels will be disrupted which interrupt air flow. This produces a chicane through which the air must flow.

The displaced portions may be formed by shearing. This may be along two parallel lines to displace planar portions of the sheet like fins out of their plane. Hence, a flat continuous sheet of material may be pressed or punched to shear portions out of the plane. This produces a sharp step at the join between each sheared portion and the remainder of the sheet.

Alternatively, the displaced portions may be produced by forming slits into the fins from one edge to form one or more tongues or strips and displacing or joggling the tongues out of the plane of the fin. Again this may produce a sharp stepped edge to each displaced portion. In a simple arrangement two parallel slits are cut into a sheet of metal to define each strip.

Where slits are formed, it is preferred that they are produced using a laser. This minimises the amount of material which is lost in making the slits. To lose material is disadvantageous as it reduces the volume of the heatsink and hence its heat dissipating ability. Of course, any other technique for forming the slits can be employed.

The displaced portions preferably extend from the edge of the fins opposite the base portion of the heatsink assembly to a point above the base. For instance, it is preferred that the bottom 5mm or so of the root of each fin has no displaced portions. It is not, however, not essential for the displaced portions to commence at an edge of the fin, and they may end nearer to or further from the base portion.

The displaced portions may be displaced out of the plane by an increasing amount the further away from the base portion they are on the fin. In all cases, however, it is preferred that they are not displaced by an amount greater than the thickness of the fin.

Preferably, each fin is made from a sheet of material approximately 1mm, 1½mm, 2mm or thereabouts in thickness. They may, of course, be thicker or thinner, depending on requirements.

Each fin may include at least two displaced portions, with one portion displaced out of the plane to one side of the fin and the other displaced in the opposite direction to the other side of the fin. The fin may comprise portions which are alternately displaced one way and then the other way across the fin.

Preferably, six displaced portions are provided on each fin. Three may be displaced to one side of the fin, the remaining three being displaced to the other side.

The dimensions of each displaced portion in a direction parallel to the base may be substantially uniform along their length. The displaced portions may be spaced apart along the fins by a greater distance than the width of each displaced portion.

The displaced portions on one fin may in a most preferred arrangement be aligned with corresponding displaced portions on adjacent fins. This provides a substantially continuous width of channel between the adjacent fins if desired, enabling the fins to be packed close together.

It is, of course not essential that all of the fins include displaced portions. For instance, only a central block of fins need have displaced portions as these tend to get hotter than the fins at the outer edge of the heatsink. At the outermost fins, turbulence may not be needed to dissipate sufficient heat.

The base may include a number of elongate slots or channels arranged in parallel on one face. A respective fin may be adapted to be gived into a slot using a thermally conductive glue to give good heat transfer from the base to the fins. Alternately, the fins could be a press-fit into the slots, or perhaps welded in place.

The fins may be made of an aluminium material, which is preferably quite free from impurities. Alternatively copper may be used. Similar materials can be used for the base portion. In general, any material with suitable heat conducting properties can be used. To shear form the displaced portions, a relatively malleable material is preferred. The base portion and fins may be of dissimilar material. Extrudible alloys are preferred for the base portion whereby the slots can be moulded in.

It is also envisaged that the base portion need not form the bottom of the heatsink. Indeed, fins may extend from any part of the base portion, and it is within the scope of the invention for fins to extend from both sides of the base portion.

There will now be described, by way of example only, two embodiments of the present invention with reference to the accompanying drawings of which:
**Figure 1** is a view of a heatsink assembly in accordance with the invention viewed from above and to the front;
**Figure 2** is a view of the heatsink assembly of Figure 1 viewed from above and to the rear;
**Figure 3** is a plan view of a central fin of the heatsink assembly of Figures 1 and 2;
**Figure 4** is an overhead view of the fin looking down towards the base portion of the heatsink assembly; and
**Figure 5** is an end view of the fin looking down the channels.

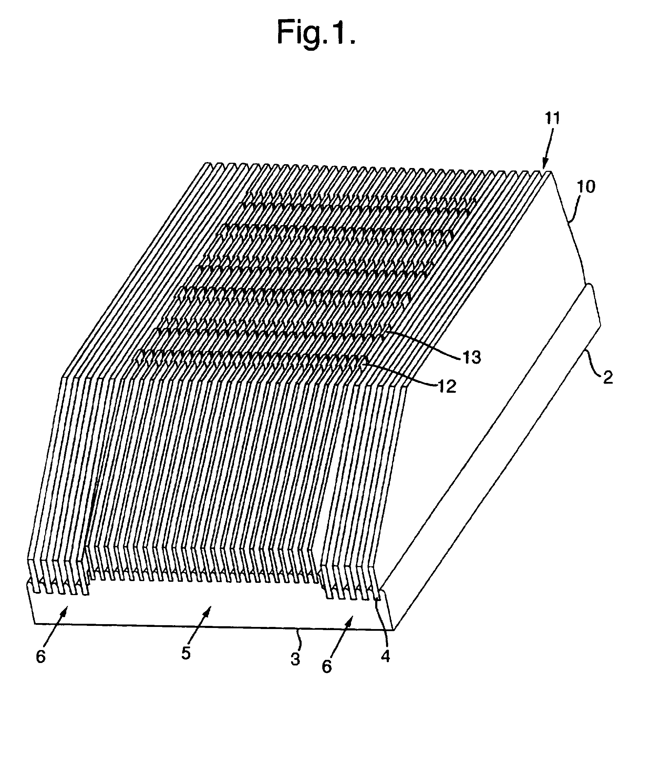

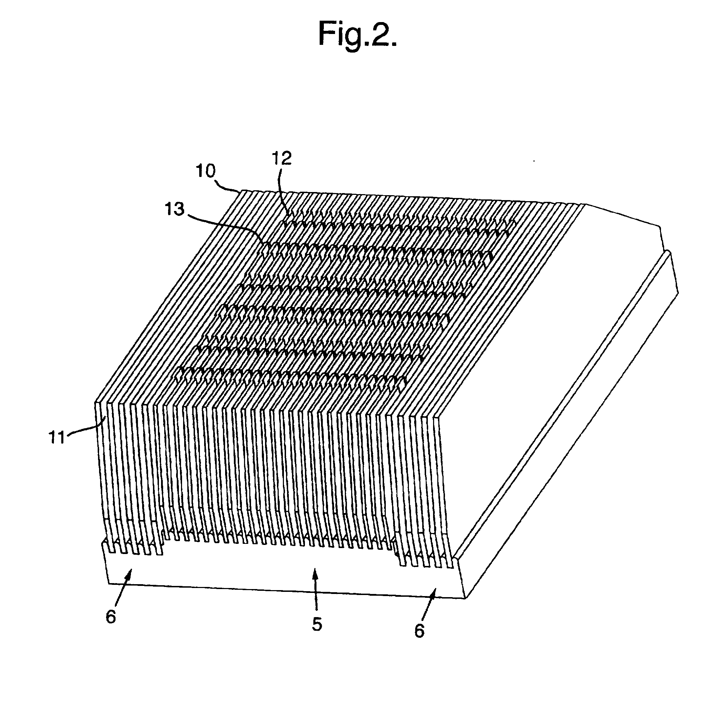

A heatsink in accordance with the present invention is illustrated in Figure 1 of the accompanying drawings from above and to the front and from above and behind in Figure 2.

The heatsink comprises a base portion of steel or aluminium. The base portion has a length of 305 mm and width of 202 mm. It has a planar underside 3 and a plurality of elongate parallel slots 4 which extend across the top face of the base portion. The slots have a width of approximately 1.5mm, a similar depth, and are spaced apart by approximately 2mm. Only one slot is labelled for clarity.

The top face of the base portion 2 is also stepped so that a central portion 5 of the base portion is thicker than the two side portions 6. The side portions 6 each have five slots 4 provided therein, with centre portion 5 having twenty four parallel slots 4. The thicker centre portion 5 improves heat dissipation since more heat will need to be radiated from the centre than the edges 6 so it will generally get hotter.

Each slot 4 is adapted to accommodate one edge of a sheet metal fin 10. The fins 10 are made of aluminium and are bonded to the base portion in the slots 4 using a thermally conductive adhesive. Once in place the fins 10 extend orthogonally from the top of the base portion 2. A number of parallel channels 11 are defined between adjacent fins 10 through which cooling air can be blown or sucked to help remove heat.

The fins 10 of the edges of the base portion 2 (four on each side) are slightly thicker than the central fins and are planar.

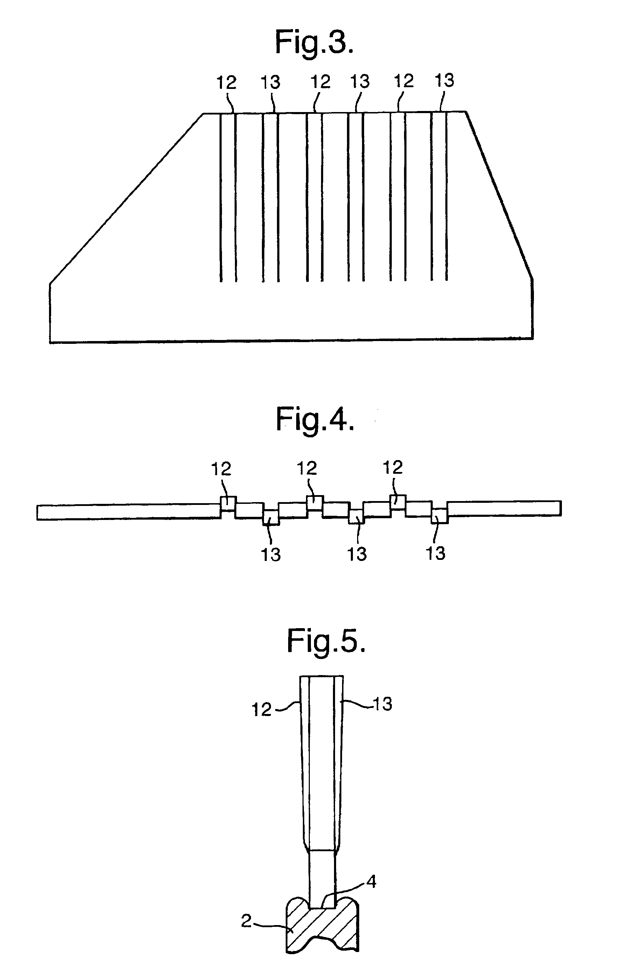

The central fins 10 are non-planar sheet like elements and essentially comprise sheets of metal in which a number of parallel displaced portions 12, 13 are provided as shown in Figures 3 and 4.

The displaced portions 12, 13 are produced by semi-shearing the sheet material to displace elongate strips or tongues of material out of the plane of the fin 10. Each strip 12, 13 extends from the edge of the fin distal from the base portion to a point approximately 5mm above the base portion. The strip is displaced out of the plane by approximately half of the thickness of the material at the edge of the fin tapering down to zero displacement at the internal end. This can be seen in figure 5 of the accompanying drawings.

On the central fins 10, each fin 10 has six equi-spaced displaced portions which extend in parallel from the free edge of the fin towards the base. Alternate displaced portions 12, 13 are displaced out of the plane of the fin in opposing directions, and each fin over the central area of the base portion is identical. The displaced portions line up to produce a channel between adjacent fins having a uniform width along its length and stepped sides.

The effect of providing the displaced portions 12, 13 is to introduce turbulence into air passing along the channels 11. It is understood that the turbulence results from air striking the edges of the displaced portions, and the overall effect is to force cold air at the top of the channels down towards the bottom of the channels which improves cooling.

In an alternative arrangement (not shown) each fin has a number of slits extending from the edge of the fin distal from the base portion orthogonally towards the base portion. In total, twelve such slits are provided, which stop approximately 5 mm above the base portion.

The slits are arranged in pairs, and the portion of the fin between each pair is displaced or "joggled" out of the plane of the sheet-like fin to form a displaced portion similar to that shown in Figure 1. The slits can be cut using a laser to have a total thickness of only around one thousand of an inch. This ensures only the minimum amount of material is lost in producing the slits. As in the first embodiment, alternate portions are displaced in opposite directions to provide a zigzag channel between adjacent fins.

It will be readily understood that many modifications can be made to the described embodiments within the scope of the invention. The number of fins, the proportion of fins having displaced portions, their dimensions and orientation may be varied almost indefinitely provided the turbulent effect that improves heat dissipation is retained.

In use, the planar base of the heatsink can be adhered to an electrical component using a thermally conductive paste. Heat generated in the component is then drawn into the heatsink and can be removed by passing cool air along the channels. The turbulent effect ensures that the amount of still air which is heated at the base of the channel is minimised by driving cool air down towards the base of the channels.

It will also be appreciated that it at least one embodiment within the scope of the invention, the fins may be integral with the base portion.

## Claims

1. A heatsink assembly comprising: a base portion (2) of a thermally conductive material and at least one fin (10) co-operating along one edge with the base portion (2) and being made of a thermally conductive material, characterised in that said fin (10) comprises a sheet-like element of which one or more portions (12, 13) of the fin are displaced out of the plane of the sheet.

2. A heatsink assembly according to claim 1 characterised in that the displaced portions (12, 13) are formed by shearing.

3. A heatsink assembly according to claim 1 characterised in that the displaced portions (12, 13) are produced by forming slits into the fins (10) from one edge to form one or more tongues or strips and displacing or joggling the tongues out of the plane of the fin (10).

4. A heatsink assembly according to claim 3 characterised in that the slits are formed using a laser.

5. A heatsink assembly according to any preceding claim characterised in that the displaced portions (12, 13) extend from the edge of the fins (10) opposite the base portion (2) of the heatsink assembly to a point above the base portion (2).

6. A heatsink assembly according to any preceding claim characterised in that the one or more displaced portions (12, 13) are displaced out of the plane by an increasing amount the further away from the base portion (2) they are on the fin (10).

7. A heatsink assembly according to any preceding claim characterised in that the fin (10) is in direct thermal contact with the base portion.

8. A heatsink assembly according to any preceding claim characterised in that each sheet-like element (10) is substantially planar.

9. A heatsink assembly according to any preceding claim characterised in that a number of fins (10) are provided and the fins (10) are arranged substantially orthogonal to the base (2).

10. A heatsink assembly according to claim 9 characterised in that each fin (10) is substantially parallel to its adjacent fin (10) to define channels between the fins (10).

11. A heatsink assembly according to any preceding claim characterised in that each fin (10) is made from a sheet of material approximately lmm, 1½mm, 2mm or thereabouts in thickness.

12. A heatsink assembly according to any preceding claim characterised in that each fin (10) includes at least two displaced portions (12, 13), with one portion (12) displaced out of the plane to one side of the fin (10) and the other (13) displaced in the opposite direction to the other side of the fin (10).

13. A heatsink assembly according to claim 12 characterised in that the fin (10) comprises displaced portions (12, 13) which are alternately displaced one way and then the other way across the fin (10).

14. A heatsink assembly according to any preceding claim characterised in that the dimensions of each displaced portion (12, 13) in a direction parallel to the base (2) are substantially uniform along their length.

15. A heatsink assembly according to any preceding claim characterised in that the displaced portions (12, 13) on one fin (10) are aligned with corresponding displaced portions (12, 13) on adjacent fins (10) to provide a substantially continuous width of channel between adjacent fins (10).

16. A heatsink assembly according to any preceding claim characterised in that the base portion (2) includes a number of elongate slots or channels arranged in parallel on one face and a respective fin (10) is adapted to be glued into a slot using a thermally conductive glue.
